Europäisches Patentamt

(19) European Patent Office

Office européen des brevets

(11) Publication number: **0 172 888**
**B1**

(12) **EUROPEAN PATENT SPECIFICATION**

(45) Date of publication of patent specification: **29.08.90**

(21) Application number: **85901242.9**

(22) Date of filing: **14.02.85**

(86) International application number:
**PCT/US85/00262**

(87) International publication number:
**WO 85/03807 29.08.85 Gazette 85/19**

(51) Int. Cl.⁵: **H 01 L 27/06, H 01 L 21/76**

(54) **VERSATILE GENERIC CHIP SUBSTRATE.**

(30) Priority: **21.02.84 US 582003**

(43) Date of publication of application:
**05.03.86 Bulletin 86/10**

(45) Publication of the grant of the patent:
**29.08.90 Bulletin 90/35**

(84) Designated Contracting States:
**BE DE FR GB NL SE**

(56) References cited:
**US-A-4 403 395**

**Patents Abstracts of Japan, vol. 8, no. 25 (E-225) (1462), 2 February 1984**

**IEEE Journal of Solid-State Circuits, vol. SC-18, no. 3, June 1983 (New York, US) B.T. Murphy: "Microcomputers: trends, technologies and design strategies", pages 236-244, see page 238, figures 4-5, column 2**

(73) Proprietor: **AMERICAN TELEPHONE AND TELEGRAPH COMPANY**
**550 Madison Avenue**
**New York, NY 10022 (US)**

(72) Inventor: **MEYER, William, George**
**2315 LaSalle Drive**
**Whitfield, PA 19609 (US)**
Inventor: **OLSON, Karel, Hugh**
**3423 Eisenhower Avenue**
**Reading, PA 19605 (US)**

(74) Representative: **Watts, Christopher Malcolm Kelway et al**
**AT&T (UK) LTD. AT&T Intellectual Property Division 5 Mornington Road**
**Woodford Green Essex IG8 OTU (GB)**

(56) References cited:
**IEEE Journal of Solid-State Circuits, vol. SC-16, no. 3, June 1981 (New York, US) E. Habekotté et al.: "A coplanar CMOS power switch", pages 212-226, see figure 17 (cited in the application)**

**Patents Abstracts of Japan, vol. 7, no. 99 (E-172) (1244), 27 April 1983**

## Description

**Background of the invention**

There are growing applications for circuits that integrate families of devices, e.g. MOS-bipolar, or diverse functions, e.g. digital-analog, high voltage-low voltage, in the same chip.

**Statement of the invention**

We have invented a versatile generic chip substrate that can accommodate a wide variety of device families in a convenient integrated standard array. The substrate contains an intra-isolated array of device sites each of which may contain one or more devices of the variety of device families.

In a preferred embodiment the generic chip substrate is used to form pairs of high voltage and low voltage CMOS devices.

**Brief description of the drawings**

Figs. 1A—1C are schematic representations of the generic chip substrate (GCS) which comprises the broad aspect of the invention;

Figs. 2A—2K ("I" omitted) are schematic representations of an exemplary group of devices that can be formed in a selected site of the GCS;

Fig. 3 is a schematic view of a preferred embodiment of the invention showing low voltage and high voltage complementary transistors in a GCS implementation;

Fig. 4 is a schematic representation of a CMOS device integrating digital and analog functions.

**Detailed description**

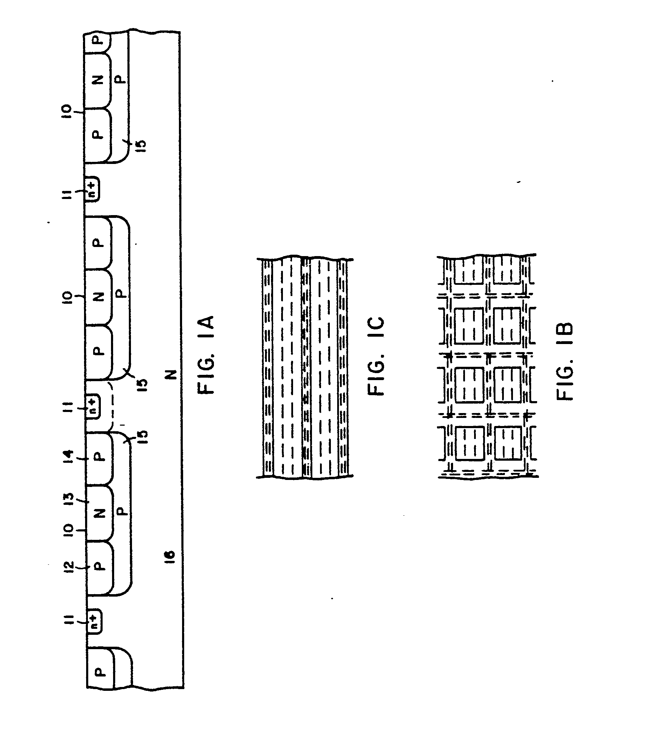

The standard generic chip substrate (GCS) is shown in Fig. 1A and comprises a semiconductor n-substrate 16 with an array of device sites 10 formed as shown. Regions 11 isolate the sites from one another. Each site comprises a sequence of p-n-p tubs 12, 13, 14 formed within a p-well 15. Dimensions of the tubs and doping levels of the various regions are a function of the actual semiconductor devices to be integrated. A slight variation of the monolithic array illustrated in Fig. 1A would have varying dimensions and doping from site to site with selected sites optimized for a given device family. However the basic ingredients would be common to each site, i.e. n and p tubs in a p-well. (Complementary structures can be used as well). The sites may be completely isolated from the nearest neighbour as shown schematically in Fig. 1B (plan view) or they can be isolated in groups or rows as indicated in Fig. 1C.

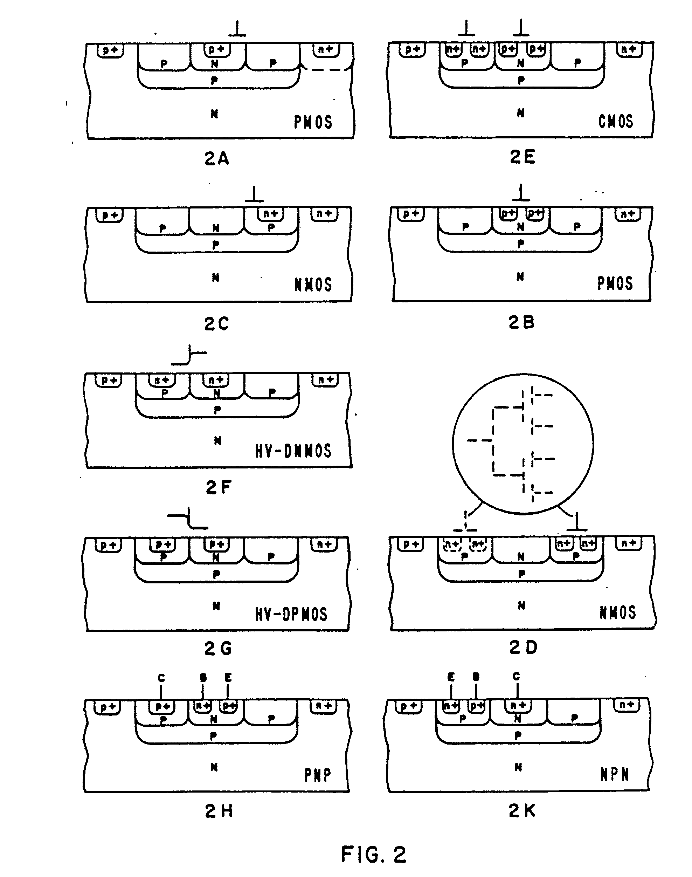

Exemplary of the wide variety of device families that can be accommodated by the GCS are those shown in Figs. 2A—2K. Other possibilities are possible. The devices in each site have the capability of being totally isolated from other devices in the array. This feature is especially useful when integrating analog and digital devices or high voltage and low voltage devices on the same chip. This layout scheme is shown in plan view in Fig. 1B. Applications will be found in which a series of, for example, low voltage CMOS pairs are advantageously laid out in a row or rows where it is unnecessary to isolate each channel from the others but it is still desirable to isolate the row from other devices, i.e. to isolate the row from the remainder of the chip substrate. In that case the isolating p-well can be formed as a continuous elongated well as shown in Fig. 1C. The basic structure of Fig. 1A is common to either layout.

Referring to Fig. 1A there is shown in dashed lines an n-tub in the separation between the p-wells. While the n-tub in itself provides a degree of isolation, it is often desirable to add the more heavily doped ($n^+$) region 11 to insure against surface inversion and inter-device leakage. Alternatively, the $n^+$ region can be used alone and the inter modular spacing optimized for the type and degree of isolation desired.

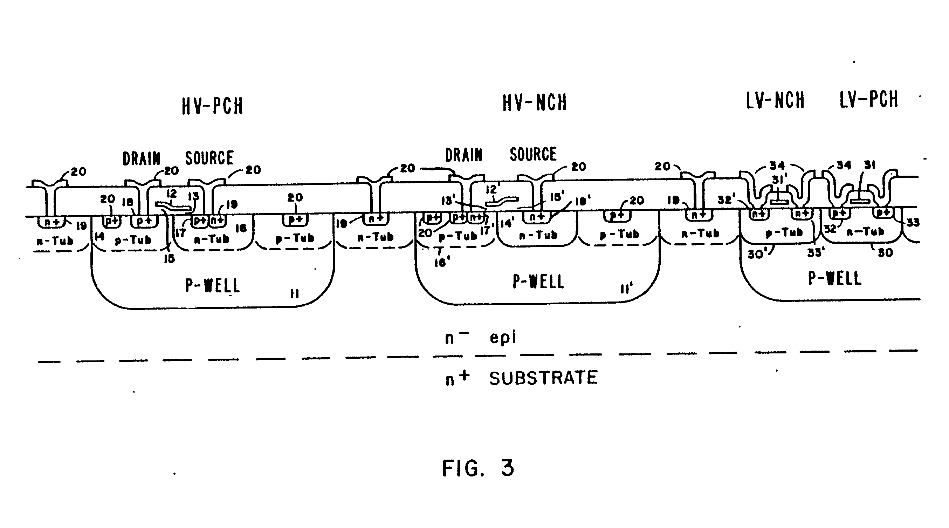

A high voltage-low voltage CMOS device is shown in Fig. 3. The high voltage device comprises source-substrate connected structures which are built within p-wells, (11 and 11') across the n-tub — p-tub boundaries, utilizing polysilicon as the gate electrodes (12 and 12'). The device structures are as follows:

1) High voltage p-channel: the n-tub region 16 under the polysilicon gate 12 and 2000A gate oxide 13 serves as the inversion region (channel), and the p-tub region 14 under the polysilicon gate 12 and field oxide 15 serves as the drift region. The source and drain are shown at 17 and 18 respectively.

2) n-channel: the p-tub region 16' under the polysilicon gate 12' and 2000A gate oxide 13' serves as the inversion region (channel), and the n-tub region 14' under the polysilicon gate 12' and field oxide 15' serves as the drift region. The source and drain are shown at 17' and 18' respectively.

The portion of the polysilicon gate which runs over the drift region serves as a field plate and insures that the drift region does not become inverted due to stray electric fields. The $n^+$ and $p^+$ guard rings 19 and 20 serve as channel stops, i.e. serve to raise the field inversion threshold. Metal contacts are shown at 20. (The gate contacts do not appear in this view).

3) Low voltage p-channel: the n-tub region 30 under the polysilicon gate 31 provides the channel between source 32 and drain 33.

4) Low voltage n-channel: the p-tub region 30' under the polysilicon gate 31' provides the channel between source 32' and drain 33'. Metal contacts (gate contacts not shown) are denoted 34.

We have fabricated both n- and p-channel HV-CMOS devices with drains to source breakdown voltages greater than 100 volts. Device characteristics are presented in the following Table. Devices had these dimensions: width=200 μm, length=15 μm, drift region 10 μm. Additional details on device structure and fabrication appear in IEEE Journal of Solid-State Circuits, E. Habekotte, B. Hoefflinger, W. Renker, and G.

Zimmer, Vol. SC-16, No. 3, June, 1981. $R_{ON}$ in the Table is on-resistance measured with $V_{GS}=10V$ and $V_{DS}-1V$. $C_{GD}$ in the Table is the gate/drain overlap capacitance.

HV CMOS device characteristics

| | |
|---|---|
| $R_{ON}$ (HV—NCH) | 1.08kΩ |
| $R_{ON}$ (HV—PCH) | 10.1kΩ |
| $C_{GD}$ | $7.67 \times 10^{-14}$F |
| $C_{GD}$/Width | $3.84 \times 10^{-16}$F/μm of width |

The addition of a p-well to the CMOS process affords a variety of additional design capabilities. For example:

1) Low voltage p-channel devices can be fabricated in n-tubs contained within a p-well (Fig. 2B), thus providing individually isolated p-channel devices.

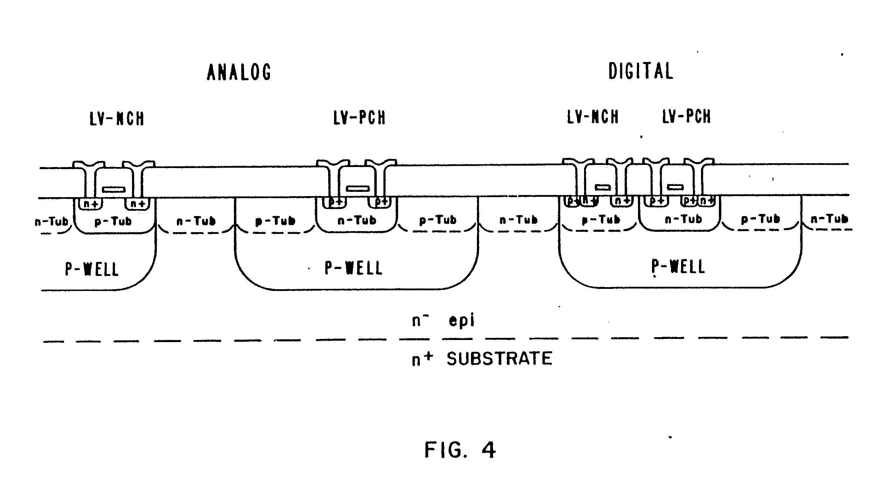

2) Low voltage digital circuits can be fabricated in one large p-well (Fig. 4), thus providing a vehicle for isolating analog and digital portions of a circuit.

3) Complementary bipolar transistors (npn and pnp can be fabricated within the p-well (Fig. 2H)). These devices are also individually isolated from each other and the substrate.

4) If one utilizes the substrate, a controlled pnpn SCR is also available (Fig. 2H).

## Claim

An integrated semiconductor structure comprising a semiconductor substrate (16) of a first conductivity type having a plurality of repeating cell units, each unit comprising a well (15) having a second conductivity type opposite to that of the substrate, each said well containing at least three contiguous tubs (12, 13, 14) of alternating conductivity type, isolating means (11) between at least selected wells for electrically isolating those wells from each other, and at least one p-n junction device (e.g. Fig. 3) formed in at least one of said tubs.

## Patentanspruch

Integrierte Halbleiterstruktur, die ein Halbleitersubstrat (16) eines ersten Leitungstyps mit einer Vielzahl sich wiederholender Zelleneinheiten umfaßt, wobei jede Einheit eine eingelassene Zone (15) eines zweiten Leitungstyps, der dem des Substrates entgegengesetzt ist, umfaßt, wobei jede eingelassene Zone wenigstens drei aneinander angrenzende Wannen (12, 13, 14) alternierenden Leitungstyps enthält, und wobei eine Isoliereinrichtung (11) zwischen wenigstens ausgewählten eingelassenen Zonen zu deren gegenseitigen Isolierung vorgesehen und wenigstens eine p-n-Übergangsanordnung (z.B. Fig. 3) in wenigstens einer der Wannen erzeugt ist.

## Revendication

Une structure à semiconducteur intégrée, comprenant un substrat semiconducteur (16) d'un premier type de conductivité qui comporte un ensemble de cellules répétitives, chaque cellule comprenant un puits (15) ayant un second type de conductivité opposé à celui du substrat, chaque puits contenant au moins trois caissons contigus (12, 13, 14) ayant des types de conductivité alternés, des moyens d'isolation (11) entre au moins des puits sélectionnés, pour isoler électriquement ces puits les uns par rapport aux autres, et au moins un dispositif à jonction p-n (figure 3, par exemple) formé dans l'un au moins des caissons.

EP 0 172 888 B1

FIG. IA

FIG. IC

FIG. IB

FIG. 2

FIG. 3

EP 0 172 888 B1

EP 0 172 888 B1

ANALOG                                    DIGITAL

LV-NCH              LV-PCH              LV-NCH    LV-PCH

FIG. 4